(19) Europäisches Patentamt / European Patent Office / Office européen des brevets

(11) **EP 3 068 840 B1**

(12) **EUROPEAN PATENT SPECIFICATION**

(45) Date of publication and mention
of the grant of the patent:
**24.07.2019 Bulletin 2019/30**

(51) Int Cl.:
***C09D 175/08*** (2006.01)  ***C08G 18/48*** (2006.01)
***H01L 31/048*** (2014.01)

(21) Application number: **14795841.7**

(22) Date of filing: **11.11.2014**

(86) International application number:
**PCT/EP2014/074263**

(87) International publication number:
**WO 2015/071256 (21.05.2015 Gazette 2015/20)**

(54) **SEALANT COMPOSITION, SOLAR CELL MODULE SEALANT PREPARED BY HARDENING THE SAME, AND METHOD FOR PRODUCING SOLAR CELL MODULE USING THE SAME**

DICHTMITTEL-ZUSAMMENSETZUNG, DURCH DESSEN HÄRTUNG HERGESTELLTES SOLARZELLENMODUL, UND VERFAHREN ZUR HERSTELLUNG EINES SOLARZELLENMODULS

COMPOSITION SCELLANT, SCELLANT DE MODULE DE CELLULE SOLAIRE PREPARE PAR DURCISSEMENT, ET PROCÉDÉ DE FABRICATION DE MODULE DE CELLULE SOLAIRE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.11.2013 JP 2013234275**

(43) Date of publication of application:
**21.09.2016 Bulletin 2016/38**

(73) Proprietor: **Covestro Deutschland AG**
**51373 Leverkusen (DE)**

(72) Inventors:
• **MITOBE, Hisao**
**Itami City**
**Hyogo 664-0853 (JP)**

• **SHIMIZU, Takehiro**
**Niihama-shi**
**Ehime 792-0012 (JP)**

(74) Representative: **Michalski Hüttermann & Partner Patentanwälte mbB**
**Speditionstraße 21**
**40221 Düsseldorf (DE)**

(56) References cited:
WO-A1-2009/126707    WO-A1-2013/141329
JP-A- H0 923 018    JP-A- 2012 015 207

**Description**

[Technical Field]

The present invention relates to the use of special compositions as a sealant composition with favorable weather resistance, vibration resistance, and productivity for use as a sealant for solar cell modules, a solar cell module sealant prepared by hardening the sealant composition, and a method for producing a solar cell module by sealing solar cells with the sealant composition.

[Background Art]

Resins such as ethylene-vinyl acetate copolymers (EVAs), silicone resins, epoxy resins, polyvinylalcohol copolymers (PVAs), polyvinylidene chlorides (PVDCs), and polyolefin-based resins have been examined and used as sealants for solar cell modules.

Although EVAs, silicone resins, and epoxy resins have an advantage that the compositions are easier in handling, they also have a disadvantage that they become colored and less transparent, leading to deterioration of power-generating efficiency, when exposed to sunlight for an extended period of time. Those resins such as PVAs, PVDCs, and polyolefin-based resins also have a problem that the compositions should be processed into a sheet or film shape and sealed under vacuum before use, thus demanding installation of expensive facilities and making the production step more complicated. These resins further have a problem that solar cells and wiring in solar cell modules are more vulnerable to damage when the solar cell modules are installed in a vibrating place, for example roadside, and thus lower in vibration resistance, because these resins are less flexible.

On the other hand, Patent Document 1 discloses a weather-resistant urethane resin sealant, the composition of which is liquid and does not demand sealing under vacuum. This document indicates a composition in combination of an aliphatic and/or alicyclic polyisocyanate and a polyol, which can be used for preparation of elastic polyurethane resins. However, it does not indicate specifically which kind of polyol material is used. In addition, the resin composition described in Patent Document 1 demands essentially an additional step of placing solar cells in a mold, injecting the resin composition into the mold, and removing air bubbles remaining in the resin composition. Degassing of resin compositions mainly containing polyurethane as the principal component demands significant labor and time and thus becomes a major concern in the production process for solar cell modules.

Alternatively, Patent Document 2 discloses a liquid-type polyurethane resin sealant prepared from a polyester-based polyol and a polyisocyanate. However, use of a polyester-based polyol demands an additional degassing step, as described in Patent Document 1, as the composition has a significantly high viscosity. Further, the hardened product, i.e., the polyurethane resin, is hydrolyzed over time, gradually losing its properties as a sealant, and thus causes a problem of low durability.

[Prior art document]

[Patent document]

[Patent document 1] Japanese Unexamined Patent Application Publication No. H09-23018
[Patent document 2] Japanese Unexamined Patent Application Publication No. 2010-157652

WO 2013/016136 A2 relates to a two-part dual-cure adhesive composition comprising a first Part (A) comprising a radiation polymerizable polyisocyanate prepolymer and a second Part (B) comprising a polyol. The disclosed adhesive can be used on substrates with electronic components to make electronic assemblies.

JP2012015207 A describes that in a solar cell module where a translucent protective face plate is arranged on the light receiving surface side of a solar cell, a specific polyurethane gel is interposed, as a cushioning material, between the solar cell and the protective face plate. The polyurethane gel has Young's modulus of 300000-20000 Pa, and the ratio of OH/NCO is larger than 1.3 and less than 2.5. Impact is absorbed and relaxed by excellent impact relaxation action of polyurethane gel, and destruction of the solar cell is prevented.

According to WO 2009/126707 A1, a polyurethane elastomer is provided. The elastomer is the reaction product of at least a prepolymer and a chain extender, where the prepolymer is the reaction product of at least one polyol and at least one aliphatic diisocyanate. The chain extender is at least one of a diol or a non-aromatic diamine.

WO 2013/141329 A1 describes providing an adhesive for solar battery back sheets obtainable by mixing (A) a urethane prepolymer having an isocyanate group at the end with (B) a polyol, wherein the urethane prepolymer (A) is obtainable by a reaction of a hydroxyl group-containing compound with an isocyanate compound, and the hydroxyl group-containing compound comprises a polycaprolactone polyol. The adhesive for solar battery back sheets is described to have satisfactory initial adhesion to a film after aging, high adhesion at high temperature, and sufficient hydrolysis resistance over a long time, and is also excellent in total valance.

[Summary of the Invention]

[Problems to be Solved by the Invention]

Objects, which was achieved under the circumstances above, is to provide a sealant composition for use as a sealant for solar cell modules superior in vibration resistance, which remains transparent even when exposed to sunlight for an extended period of time, demands no sealing under vacuum and thus demands no degassing of the sealant composition injected into the space between a pair of plate-shaped members where solar cells are placed, a solar cell module sealant prepared by hardening the sealant composition, and a method for producing a solar cell module by sealing solar cells with the sealant composition. The solar cell module prepared by sealing solar cells with the sealant is superior in weather resistance and vibration resistance

and additionally can be prepared at low cost.

[Means to Solve the Problems]

The present invention is defined by the independent claim.
In particular, the present invention provides a method for producing a solar cell module by sealing solar cells with a solar cell module sealant, comprising the steps of placing solar cells between a pair of plate-shaped members placed at a particular distance, injecting a sealant composition comprising a polyol component (component A) and at least either one of aliphatic and alicyclic isocyanates (component B), wherein 93 to 100 wt % of the component A is the following polyether polyol (X), wherein the polyether polyol (X) is prepared by ring-opening addition polymerization of a compound having an average functionality of 2 to 4 and containing at least either one of hydroxyl and amino groups with an alkylene oxide into the space between the pair of plate-shaped members having the solar cells, and hardening the injected sealant composition without degassing thereof and wherein the polyether polyol (X) satisfies the requirements of a molecular weight of 3000 to 8000, wherein the molecular weight is determined according to the description (paragraph 13), a hydroxyl value of 20 to 80 mg KOH/g, wherein the hydroxyl value is determined according to JIS K1557-1 (acetylation method), and a viscosity (determined according to JIS K1557-5) of 1500 mPa·s/25°C or lower.
An aspect is the use of a composition, comprising a polyol component (component A) and at least either one of aliphatic and alicyclic isocyanates (component B), wherein 93 to 100 wt % of the component A is the following polyether polyol (X), wherein the polyether polyol (X) is prepared by ring-opening addition polymerization of a compound having an average functionality of 2 to 4 and containing at least either one of hydroxyl and amino groups with an alkylene oxide, as a sealant for solar cell modules.
A second aspect is a solar cell module sealant prepared by hardening the sealant composition of the first aspect, wherein the solar cell module sealant has the following physical properties: an Asker A hardness of 60 or less, an elongation of 500% or more, and a 100% modulus of 1.0 MPa or less. A third aspect is a method for producing a solar cell module by sealing solar cells with a solar cell module sealant, comprising the steps of placing solar cells in a space between a pair of plate-shaped members placed at a particular distance, injecting the sealant composition of the first aspect into the space between a pair of plate-shaped members holding the solar cells, and hardening the sealant composition thus injected without degassing.
In order to obtain a solar cell module that is superior in weather resistance and vibration resistance and can be prepared at low cost, the inventors paid attention to the solar cell module sealant for sealing solar cells and conducted studies. As a result, the authors have found that the object can be achieved by sealing solar cells placed in a space between a pair of plate-shaped members with a particular sealant composition and made the present invention.

[Effect of the Invention]

As described above, the composition is used as a sealant composition for solar cell modules, comprising a polyol component (component A) and at least either one of aliphatic and alicyclic isocyanates (component B), wherein 93 to 100 wt % of the component A is polyether polyol (X). Accordingly, the resulting sealant composition is less viscous and resistant to foaming by incorporation of air during injection and also to residual of the air bubbles therein. The sealant prepared by hardening the sealant composition is also resistant to weathering and highly elastic, and thus, it is possible to produce easily at low cost solar cell modules that can be installed in a vibrating place such as roadside.

The polyether polyol (X) satisfying the conditions of a molecular weight of 3000 to 8000, a hydroxyl value of 20 to 80 mg-KOH/g, and a viscosity of 1500 mPa·s/25°C or lower is preferable, as the balance between the viscosity of the sealant composition and the elasticity of the sealant prepared by hardening the same is more favorable.

The molecular weight, as used in the present invention, is the theoretical molecular weight that can be calculated from the measured hydroxyl value of the polyether polyol and the functionality of the raw material for production of the polyether polyol according to the following Formula (1) (for example when the hydroxyl value is 28 mg-KOH/g and the functionality 3, the molecular weight is 56100/28×3=6010). 56100 is a value of the molecular weight of KOH, as expressed by mg.

$$56100/\text{hydroxyl value (mg-KOH/g)} \times \text{functionality} = \text{molecular weight} \dots (1)$$

The hydroxyl value can be determined according to JIS K1557-1(acetylation method), while the viscosity can be determined according to JIS K1557-5.

A solar cell module sealant that is prepared by hardening the sealant composition according to the present invention and has the following physical properties: an Asker A hardness of 60 or less, an elongation of 500% or more, and a 100% modulus of 1.0 MPa or less is superior in weather resistance and more favorable in vibration resistance. Thus, it can be used for solar cell modules that are to be installed in a vibrating place such as roadside.

Because the production method for a solar cell module according to the present invention does not demand the process of sealing the sealant composition in the sheet shape under vacuum or the process of degassing the sealant composition injected into the space between a pair of sheet-shaped members where solar cells are placed, it is possible to produce easily at low cost a solar cell module superior in weather resistance and vibration resistance.

[Brief Description of the Drawings]

Figure 1 is a schematic top view illustrating a solar cell module prepared in an embodiment of the present invention.
Figure 2 is a schematic crosssectional view of the solar cell module of Figure 1 along the X-X' cross section.
Figure 3 is a drawing explaining the method for producing a solar cell module in an embodiment of the present invention.

[Mode for Carrying out the Invention]

Hereinafter, favorable embodiments of the invention will be described.

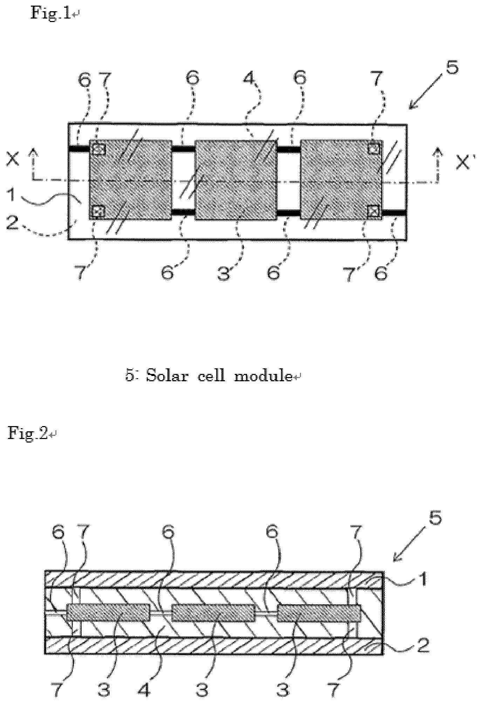

Figure 1 is a top view of a CIGS solar cell module 5 prepared in an embodiment of the present invention, wherein solar cells 3, wiring 6, and supporting rods 7 sealed with a transparent solar cell module sealant 4, and a rear plate-shaped member 2 are observable through a transparent front plate-shaped member 1. Figure 2 is a crosssectional view of the solar cell module along the X-X' sectional plane. Hereinafter, the configuration of the solar cell module 5 will be described in detail. The configurations in Figures 1 and 2 are shown schematically and the actual thickness, size, and others may be different from those shown there (the same shall apply in the Figures below).

For improvement of resistance during long-term outdoor use, the solar cell module 5 has a transparent front plate-shaped member 1 for example of a reinforced superwhite glass superior in transparency and impact resistance and a rear plate-shaped member 2 for example of a reinforced glass superior in impact resistance and also multiple solar cells 3 electrically connected to each other for example via wiring 6 placed at a predetermined position with resin supporting rods 7 between the plate-shaped members, and the area surrounding the solar cells 3 is sealed with a solar cell module sealant 4 higher in elasticity and resistant to discoloration even after photoirradiation for a long period.

The solar cell module sealant 4 is a hardened product of a special sealant composition 4'. The present invention is most characteristic in that the special sealant composition 4' is used as the sealant for the solar cell module. Hereinafter, the sealant composition 4' will be described in detail.

The sealant composition 4' comprises a polyol component (component A) and at least either one of aliphatic and alicyclic isocyanates (component B), and 93 to 100 wt % of the component A is a polyether polyol (X) prepared by ring-opening addition polymerization of a compound having an average functionality of 2 to 4 and containing at least either one of hydroxyl and amino groups with an alkylene oxide. Use of the polyether polyol (X) entirely or in an amount of 93 wt % or more gives a solar cell module sealant 4 sufficiently lower in viscosity in the stage of composition but superior not only in impact resistance and weather resistance but also in salt spray resistance, dimensional stability, moisture resistance, chemical resistance, water absorption, insulating properties, and others after hardening.

Examples of the polyether polyols (X) include hydroxyl group-containing compounds such as propylene glycol, diethylene glycol, glycerol, trimethylolpropane, and pentaerythritol; compounds containing amino and hydroxyl groups such as monoethanolamine, diethanolamine, and triethanolamine; and/or compounds obtained by ring-opening addition polymerization of an amino-group-containing compound such as ethylenediamine or diaminotoluene with an alkylene oxide such as ethylene oxide (EO) or propylene oxide (PO).

Among the compounds above, the polyether polyol (X) is particularly preferably a relatively longer-chain polyether polyol satisfying the conditions of a molecular weight of 3000 to 8000, a hydroxyl value of 20 to 80 mg-KOH/g, and a viscosity of 1500 mPa·s/25°C or lower in the 100% resin state. When the molecular weight is less than 3000, the polyurethane resin after hardening may have insufficient viscoelasticity, while when the molecular weight is more than 8000, it may have excessively high viscosity. Alternatively when the hydroxyl value is less than 20, it may have excessively high viscosity, while when it is more than 80, the hardened polyurethane resin may have insufficient viscoelasticity. Yet alternatively when the viscosity is more than 1500 mPa·s/25°C, it may become too viscous, possibly causing a problem of declined productivity, as described above.

The polyether polyol (X) has an average functionality of 2 to 4, as described above. It is because, when the average functionality is less than 2, the hardened product may have insufficient weather resistance and heat resistance and is thus improper as solar cell module sealant, and alternatively when the average functionality is more than 4, the hardened product may have insufficient viscoelasticity.

When a polyether polyol (X) having many EO units added to the molecular terminals is used, the sealant becomes more efficient in hardening reaction but also becomes more hygroscopic. Thus, the content of the terminal EO units is preferably 0 to 20 wt % and more preferably 0 to 15 wt % with respect to the total amount of alkylene oxides. Such a polyether polyol (X) may be a single compound or a mixture of two or more compounds.

The component A can contain, in addition to the polyether polyol (X), a short-chain glycol having a functionality of 2 to 4, a polyether polyol, or the like as crosslinking agent for adjustment of the physical properties of the sealant composition and also of the hardened product thereof. Examples of the crosslinking agents include ethylene glycol, 1,3-propanediol, 1,2-propanediol, 2-methyl-1,3-propanediol, 1,4-butanediol, 1,3-butanediol, 1,4-pentanediol, 1,5-pentanediol, 1,6-hexanediol, 1,5-hexanediol, 1,2-hexanediol, 2,5-hexanediol, octanediol, nonanediol, decanediol, diethylene glycol, triethylene glycol, dipropylene glycol, cyclohexanediol, trimethylolpropane, glycerol, 2-methylpropane-1,2,3-triol, 1,2,6-hexanetriol, pentaerythritol, and the like. The amount of the crosslinking agent used is preferably 0 to 8 wt parts and more preferably 0 to 7 wt parts, with respect to 100 wt parts of the sealant composition. When the content of the crosslinking agent is regulated in the range above, the sealant composition becomes more efficient in hardening reaction, without the viscoelasticity of the polyurethane resin being impaired. The component A may also contain r polyol components additionally.

Examples of the aliphatic and alicyclic isocyanates of component B, which is used together with the component A, include hexamethylene diisocyanate (HDI), isophorone diisocyanate (IPDI), 4,4'-methylenebiscyclohexyl isocyanate (hydrogenated MDI), norbornene diisocyanate (NBDI), and the modified products thereof such as urethane-modified products, isocyanurate-modified products, biuret-modified products, and allophanate-modified products. They may be used alone or in combination of two or more. In particular, diisocyanates such as HDI and IPDI, which are less viscous, can be used favorably in the present invention. Modified products thereof, which have high molecular weight, are generally slightly more viscous, but they can be used in the range that does not have significant influence on viscosity after they are mixed with the polyether polyol (X). The diisocyanates above and the modified products thereof can be used in combination.

The ratio of the component A to B is preferably regulated to a molar ratio of NCO/OH group of 0.9 or more and 1.1 or less. It is because, when the molar ratio is less than 0.9, the sealant composition may become less lower in crosslinking density and cannot satisfy the requirements in weather resistance and heat resistance, while when it is more than 1.1, the sealant composition contains an excess amount of NCO groups and thus may cause a problem of foaming, independently of the viscosity. In the present invention, the molar ratio of NCO/OH group is calculated, based on the ratio of (isocyanate weight)/(isocyanate equivalence) to (polyol weight)/(polyol equivalence) actually blended in the sealant. The isocyanate equivalence can be calculated by 4200/NCO% and the polyol equivalence can be calculated by 56100/(hydroxyl group functionality).

The sealant composition 4' may contain, as needed, an ultraviolet absorbent, a degradation inhibitor, or a discoloration inhibitor for improvement of photostability. Examples thereof include benzophenone-based compounds such as 2-hydroxy-4-methoxybenzophenone and 2,2'-dihydroxy-4-methoxybenzophenone; benzotriazole-based compounds such as 2-(2'-hydroxy-3,3-dibutylphenyl)benzotriazole; and salicylic acid ester-based compounds. For further improvement of photostability, a hindered amine-, hindered phenol-, or phosphite-based compound may be used additionally.

The sealant composition 4' may be hardened at a temperature of about 20°C, but hardening at a temperature of 50 to 80°C is preferable, as it permits increase of hardening velocity. The sealant composition 4' may contain additionally a common urethanation catalyst for acceleration of the hardening reaction. Examples of the catalysts include organic tin-, organic zinc-, organic zirconium-, tertiary amine-based urethanation catalysts.

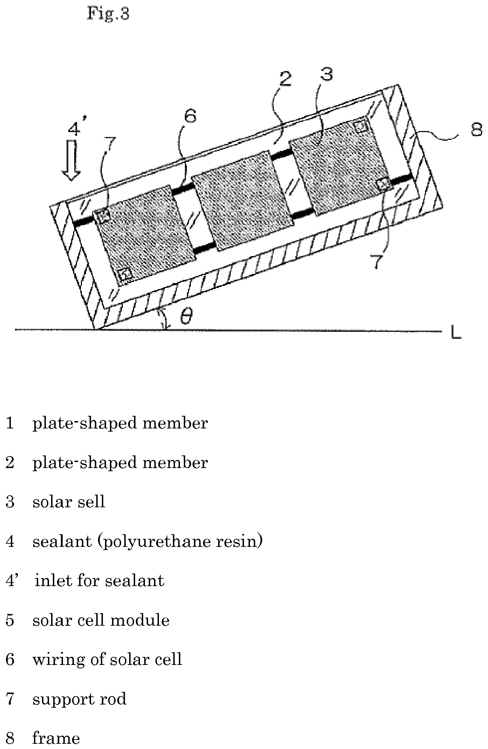

Hereinafter, a method for production of a solar cell module using the sealant composition 4' will be described with reference to Figure 3.

First, a front plate-shaped member 1 and a rear plate-shaped member 2 are placed respectively along the side walls facing each other of a solar cell module frame 8 separately prepared (the front plate-shaped member 1 is not drawn in Figure 3.) Multiple solar cells 3 electrically connected to each other by wiring 6 are placed at a predetermined place between the front plate-shaped member 1 and the rear plate-shaped member 2 with supports 7. Separately, a sealant composition 4' that is blended and adjusted to have predetermined physical properties is prepared and degassed. It is injected into the frame, as the module frame 8 is tilted at an angle of $\theta$ from the horizontal line L, as shown in Figure 3. After injection, the module frame 8 is brought back to the original state (horizontal) and left still in the state. Because the sealant composition 4' injected then is less viscous and does not contain air incorporated therein, there is no need for degassing. The sealant composition 4' is then hardened at a temperature of 50°C and converted to a solar cell module sealant 4 superior in the various properties described above, which is then separated from the mold, giving a solar cell module 5 with favorable properties (see Figure 1).

It is possible according to the production method to produce easily at low cost a solar cell module 5 superior in weather resistance and vibration resistance, without need for the process of sealing the sealant composition 4' in the sheet shape under vacuum or the process of degassing the sealant composition 4' injected into the solar cell module frame (between the front plate-shaped member 1 and the rear plate-shaped member 2 where solar cells 3 are placed).

Conventional sealants, which contain various relatively high-hardness low-flexibility resins, caused a problem that they deform or crack, breaking the internal solar cells, when used for an extended period of time. In contrast, it is possible by using a particular polyisocyanate and a particular polyol described above in combination at a particular blending rate, as in the sealant composition 4' according to the present invention, to seal a solar cell module with a low-hardness flexible polyurethane resin that raises no concern about damage of internal solar cells. The aliphatic or alicyclic polyurethane resin (solar cell module sealant 4) is superior not only in transparency, weather resistance, and heat resistance but also in salt spray resistance, dimensional change, moisture resistance, chemical resistance, water absorption, insulating properties, and others, and thus optimally suited for use in sealing solar cell modules.

Various resins may be used, replacing glass, for the front plate-shaped member 1 and the rear plate-shaped member 2 of the solar cell module 5. In addition, a flexible member such as sheet or film may be used, replacing the plate-shaped member. The front plate-shaped member 1 and rear plate-shaped member 2 may be the same as or different from each other. However, the front plate-shaped member 1 should be a weather-resistant transparent member. It is possible by using a transparent member as the rear plate-shaped member 2 to obtain a solar cell module superior in light collection efficiency at both faces.

The distance between the front plate-shaped member 1 and the rear plate-shaped member 2 (thickness of module sealant 4) can be determined arbitrarily according to application and required properties, if the sealant composition 4' is injectable and its favorable insulating properties and transparency are preserved. It is generally approximately 1 mm to 100 mm.

One preferred object is a sealant composition for use as a sealant for solar cell modules, comprising a polyol component (component A) and at least either one of aliphatic and alicyclic isocyanates (component B), wherein 93 to 100 wt % of the component A is the following polyether polyol (X), wherein the polyether polyols (X) is prepared by ring-opening addition polymerization of a compound having an average functionality of 2 to 4 and containing at least either one of hydroxyl and amino groups with an alkylene oxide.

Further preferred is the the sealant composition according to the above mentioned object, wherein the polyether polyol (X) satisfies the requirements of a molecular weight of 3000 to 8000, a hydroxyl value of 20 to 80 mg-KOH/g, and a viscosity of 1500 mPa·s/25°C or lower.

A second preferred object is a solar cell module sealant prepared by hardening the sealant composition according to the first mentioned object above, wherein the solar cell module sealant has the physical properties of an Asker A hardness of 60 or less, an elongation of 500% or more, and a 100% modulus of 1.0 MPa or less.

A third preferred object A method for producing a solar cell module by sealing solar cells with a solar cell module sealant, comprising the steps of placing solar cells between a pair of plate-shaped members placed at a particular distance, injecting the sealant composition according to according to the first mentioned object above into the space between the pair of plate-shaped members having the solar cells, and hardening the injected sealant composition without degassing thereof.

Hereinafter, the present invention will be described with reference to Examples and Comparative Examples. It should be understood that the present invention is not limited thereby.

[Example]

[Example 1]

(Preparation of sealant composition)

100 wt parts of a component A having a molecular weight of 4800, a hydroxyl value of 35 mg-KOH/g, and a viscosity of 800 mPa·s/25°C prepared by ring-opening addition polymerization of glycerol having a functionality of 3 (as initiator) with alkylene oxide [polyether polyol (X) (content of terminal EO units: 10%)], 2.0 wt parts of a hindered amine (Sanol LS292 produced by Sankyo Organic Chemicals) as photostabilizer, and 1.0 wt part of dibutyltin dilaurate as reaction catalyst were added and mixed thoroughly with a stirrer and degassed under reduced pressure. 7.2 wt parts of isophorone diisocyanate (Desmodur I produced by Bayer MaterialScience, NCO%: 37.8) as component B was added thereto and the mixture was stirred with a stirrer, while caution was given not to make air bubbles incorporated.

(Preparation of solar cell module)

As described in the embodiment above, a front plate-shaped member of glass having a thickness of 3 mm and a rear plate-shaped member of glass having a thickness of 3 mm were placed in a solar cell module frame separately prepared at a distance of 6 mm, and 3 solar cells electrically connected to each other were placed between them. The module frame was tilted at an angle of 20° from the horizontal line and the sealant composition was injected gently into the frame. As no air bubbles were incorporated into the sealant composition then, there was no need for degassing the sealant composition after injection. After injection of the sealant composition, the module frame was brought back to its original horizontal state and the sealant composition was hardened as it was left still at 50°C for 6 hours. Separation of the hardened product from the module frame gave a solar cell module having the solar cells placed between the front and rear plate-shaped members sealed with the sealant (sealant composition being hardened).

[Examples 2 to 4 and Comparative Example 1]

Solar cell modules were prepared in a manner similar to Example 1, except that the sealant composition was changed to that shown in Table 1 below. The hydrogenated MDI used was Desmodur W produced by Bayer MaterialScience and the HDI isocyanurate derivative used was Desmodur N3600 produced by Bayer MaterialScience (NCO%: 23.0%, viscosity: 1100mPa/25°C).

All of the solar cell modules of Examples and Comparative Examples above operated normally. Six properties, i.e., hardness (Asker A), tensile strength (MPa), 100% modulus (MPa), elongation (%), transparency (%), and weather resistance, of the sealants used for these solar cell modules were measured or observed according to the following procedures and the results are summarized in Table 1. For the measurement or observation above, hardened products prepared similarly to the sealants used for the solar cell modules of Examples and Comparative Examples were used as the samples respectively corresponding to the Examples and Comparative Examples.

1. Hardness (Asker A)

The hardness was determined according to the method of JIS K6253-3 using the type-A durometer according to JIS K6253-3. The hardness was determined immediately after insertion of the needle (for 1 second or less).

2. Tensile strength (MPa)

The tensile strength was determined according to JIS K6400-5, using a dumbbell #1-shaped sample.

3. 100% modulus (MPa)

The 100% modulus was determined according to JIS K6400-5, using a dumbbell #1-shaped sample as the strength at an elongation of 100%.

4. Elongation (%)

The elongation was determined according to JIS K6400-5 using a dumbbell #1-shaped sample.

5. Transparency (%)

The transparency was determined according to JIS K7361, on NDH-2000 produced by Nippon Denshoku Industries Co., Ltd., using a sample having a thickness of 2 mm.

6. Weather resistance

The weather resistance was examined by determining whether the sample became discolored after storage in QUV Weather Tester produced by Q-Lab (UVA340 lamp) at an ambient temperature of 60°C for 2000 hours and the sample without discoloration was indicated by o.

[Table 1]

| | | Example 1 | Example 2 | Example 3 | Example 4 | Comparative Example 1 |
|---|---|---|---|---|---|---|
| Component A | Polyether polyol (X) | 100 | 100 | 100 | 95 | 90 |
| | 1,4-butanediol | 0 | 0 | 0 | 5 | 10 |
| Component B | IPDI | 7.2 | 0 | 0 | 19.9 | 32.5 |
| | Hydrogenated MDI | 0 | 8.7 | 0 | 0 | 0 |
| | HDI isocyanurate derivative | 0 | 0 | 12.0 | 0 | 0 |
| Catalyst | Dibutyltin dilaurate | 1 | 1 | 1 | 1 | 1 |
| Photostabilizer | Hindered amine | 2 | 2 | 2 | 2 | 2 |
| NCO/OH ratio | | 1.05 | 1.05 | 1.05 | 1.05 | 1.05 |
| Hardness (Asker A) | | 30 | 35 | 50 | 56 | 88 |
| Tensile strength (MPa) | | 1.5 | 2.1 | 2.5 | 2.5 | 10.2 |
| 100% Modulus (MPa) | | 0.4 | 0.5 | 0.6 | 0.8 | 2.8 |
| Elongation (%) | | > 1000 | > 1000 | 700 | 600 | 250 |
| Transparency (%) | | 90 | 90 | 91 | 91 | 89 |
| Weather resistance | | ○ | ○ | ○ | ○ | ○ |

As shown in Table 1, all of the sealants of Example 1 to 4 showed favorable physical properties, indicating that they are favorable as sealants for solar cell modules. On the other hand, the sealant of Comparative Example 1 was similar in weather resistance to those of Examples, but shown to contain air bubbles therein and to be inferior in physical properties and unsuitable as a sealant for solar cell modules.

[Industrial Applicability]

The hardened product of the sealant composition according to the present invention can be used effectively as a solar cell module sealant superior all in weather resistance, vibration resistance, and productivity.

**Claims**

1. A method for producing a solar cell module by sealing solar cells with a solar cell module sealant, comprising the steps of placing solar cells between a pair of plate-shaped members placed at a particular distance, injecting a sealant composition comprising a polyol component (component A) and at least either one of aliphatic and alicyclic isocyanates (component B), wherein 93 to 100 wt % of the component A is the following polyether polyol (X), wherein the polyether polyol (X) is prepared by ring-opening addition polymerization of a compound having an average functionality of 2 to 4 and containing at least either one of hydroxyl and amino groups with an alkylene oxide into the space between the pair of plate-shaped members having the solar cells, and hardening the injected sealant composition without degassing thereof and

wherein the polyether polyol (X) satisfies the requirements of a molecular weight of 3000 to 8000, wherein the molecular weight is determined according to the description (paragraph 13), a hydroxyl value of 20 to 80 mg KOH/g, wherein the hydroxyl value is determined according to JIS K1557-1 (acetylation method), and a viscosity (determined according to JIS K1557-5) of 1500 mPa·s/25°C or lower.

## Patentansprüche

1. Verfahren zum Herstellen eines Solarzellenmoduls durch Versiegeln von Solarzellen mit einem Dichtungsmittel für ein Solarzellenmodul, umfassend die Schritte

des Anordnens von Solarzellen zwischen einem Paar plattenförmiger Elemente, die mit einem bestimmten Abstand angeordnet sind,

des Einspritzens in den Raum zwischen dem Paar plattenförmiger Elemente, der die Solarzellen enthält, einer Dichtungsmittelzusammensetzung, die eine Polyolkomponente (Komponente A) und mindestens eines von aliphatischen und alicyclischen Isocyanaten (Komponente B) aufweist, wobei 93 bis 100 Gew.-% der Komponente A das folgende Polyetherpolyol (X) sind, wobei das Polyetherpolyol (X) hergestellt ist durch Ringöffnungs-Additionspolymerisation einer Verbindung mit einer durchschnittlichen Funktionalität von 2 bis 4 und wenigstens umfassend eines von Hydroxyl- und Aminogruppen mit einem Alkylenoxid und

des Härtens der eingespritzten Dichtungsmittelzusammensetzung ohne Entgasung derselben,

wobei das Polyetherpolyol (X) die Anforderungen erfüllt eines Molekulargewichts von 3000 bis 8000, wobei das Molekulargewicht gemäß der Beschreibung (Absatz 13) bestimmt wird, eines Hydroxylwerts von 20 bis 80 mg KOH/g, wobei der Hydroxylwert bestimmt wird gemäß JIS K1557-1 (Acetylierungsverfahren), und einer Viskosität (bestimmt gemäß JIS K1557-5) von 1500 mPa·s/25°C oder niedriger.

## Revendications

1. Procédé de production d'un module de cellule solaire en scellant des cellules solaires avec un agent d'étanchéité de module de cellule solaire, comprenant les étapes de mise en place de cellules solaires entre une paire d'éléments en forme de plaques placés à une distance particulière, d'injection d'une composition d'agent d'étanchéité comprenant un composant polyol polyéther (composant A) et au moins au choix l'un parmi des isocyanates aliphatique et alicyclique (composant B), où de 93 à 100 % en poids du composant A sont le polyol polyéther suivant (X), où le polyol polyéther (X) est préparé par une polymérisation par addition avec ouverture de cycle d'un composé ayant une fonctionnalité moyenne de 2 à 4 et contenant au moins au choix un parmi un groupe hydroxyle et un groupe amine avec un oxyde d'alcylène dans l'espace entre la paire d'éléments en forme de plaques ayant les cellules solaires, et de durcissement de la composition d'étanchéité injectée sans dégazage de celle-ci, et où le polyol polyéther (X) satisfait aux exigences d'un poids moléculaire de 3000 à 8000, où le poids moléculaire est déterminé selon la description (paragraphe 13), un indice d'hydroxyle de 20 à 80 mg de KOH/g, où l'indice d'hydroxyle est déterminé selon la norme JIS K1557-1 (méthode par acétylation) et une viscosité (déterminée selon la norme JIS K1557-5) de 1500 mPa · s/25 °C ou plus faible.

Fig.1

5: Solar cell module

Fig.2

EP 3 068 840 B1

Fig.3

1  plate-shaped member

2  plate-shaped member

3  solar sell

4  sealant (polyurethane resin)

4'  inlet for sealant

5  solar cell module

6  wiring of solar cell

7  support rod

8  frame

11

**REFERENCES CITED IN THE DESCRIPTION**

**Patent documents cited in the description**

- JP H0923018 B
- JP 2010157652 A
- WO 2013016136 A2
- JP 2012015207 A
- WO 2009126707 A1
- WO 2013141329 A1